(19) Europäisches Patentamt
European Patent Office
Office européen des brevets

(11) EP 4 730 922 A1

(12) EUROPEAN PATENT APPLICATION
published in accordance with Art. 153(4) EPC

(43) Date of publication:
22.04.2026 Bulletin 2026/17

(21) Application number: 24825692.7

(22) Date of filing: 31.05.2024

(51) International Patent Classification (IPC):
H05K 1/03 (2006.01)    B32B 15/08 (2006.01)

(52) Cooperative Patent Classification (CPC):
B32B 15/08; H05K 1/03

(86) International application number:
PCT/JP2024/020031

(87) International publication number:
WO 2024/262285 (26.12.2024 Gazette 2024/52)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 19.06.2023 JP 2023099998

(71) Applicant: Resonac Corporation
Tokyo 105-7325 (JP)

(72) Inventors:
• TONOUCHI Shunsuke
Tokyo 105-7325 (JP)
• MIZUSHIMA Etsuo
Tokyo 105-7325 (JP)
• KITAJIMA Takayo
Tokyo 105-7325 (JP)
• NAKANISHI Kota
Tokyo 105-7325 (JP)

(74) Representative: Hoffmann Eitle
Patent- und Rechtsanwälte PartmbB
Arabellastraße 30
81925 München (DE)

(54) **SUBSTRATE, PRINTED CIRCUIT BOARD, AND SEMICONDUCTOR PACKAGE**

(57) Disclosed are a substrate including a metal clad laminate including a metal foil and a cured product of a prepreg, and an insulating layer laminated on at least one surface of the metal clad laminate, in which the metal clad laminate has 400 $\mu$m or more of an average thickness $T_1$ measured by a predetermined method using a laser displacement gauge, and 10 $\mu$m or less of an absolute value $D_1$ of a difference between a maximum value and a minimum value of a thickness, and a printed wiring board and a semiconductor package using the substrate.

[Fig. 1]

## Description

Technical Field

The present disclosure relates to a substrate, a printed wiring board, and a semiconductor package.

Background Art

In electronic devices such as a mobile communication device represented by a mobile phone, a network infrastructure device such as a base station device, a server, or a router, or a large computer, the speed and the capacity of a signal to be used are increasing year by year. Accordingly, in order to improve transmission characteristics, it is necessary to suppress a variation in characteristic impedance in a substrate material of a printed wiring board mounted on the electronic devices.

PTL 1 discloses a semi-cured synthetic resin sheet, which is a material of an insulating layer, capable of producing a multilayer wiring substrate that makes it easy to achieve impedance matching of electronic components, in which the semi-cured synthetic resin sheet used as the material of the insulating layer of the multilayer wiring substrate contains a cured synthetic resin sphere.

Citation List

Patent Literature

PTL 1:JP 2002-141670 A

Summary of Invention

Technical Problem

However, in recent years, there has been a significant increase in the speed of signals, and therefore, in order to maintain signal quality, more advanced control of characteristic impedance than before has been required. In particular, according to studies by the present inventors, it has been found that a variation in characteristic impedance tends to increase in a substrate using a laminate having a large thickness, and improvement thereof is required.

In view of such a current situation, an object of the present embodiment is to provide a substrate having a small variation in characteristic impedance, a printed wiring board using the substrate, and a semiconductor package.

Solution to Problem

As a result of studies to solve the above problems, the present inventors have found that the above problems can be solved by the present embodiment described below.

[1] A substrate including:

a metal clad laminate including a metal foil and a cured product of a prepreg; and
an insulating layer laminated on at least one surface of the metal clad laminate,
in which the metal clad laminate has 400 $\mu$m or more of an average thickness $T_1$ measured by the following method using a laser displacement gauge, and 10 $\mu$m or less of an absolute value $D_1$ of a difference between a maximum value and a minimum value of a thickness,
(Method for measuring the average thickness $T_1$ and the absolute value $D_1$ of the difference between maximum value and minimum value of the thickness of the metal clad laminate):

In a plan view of the metal clad laminate, four rectangular thickness measurement regions each having a vertical length of 60 mm and a horizontal length of 60 mm are set at any positions not overlapping each other;
In the rectangular thickness measurement region, a vertical measurement line is set to twelve lines every 5 mm from a position 2.5 mm away from a left side. On each vertical measurement line, thickness measurement is performed at intervals of 1 mm in a longitudinal direction with a starting point of less than 1 mm (however, not 0 mm) from an upper side;
In addition, in the rectangular thickness measurement region, a horizontal measurement line is set to twelve lines every 5 mm from a position 2.5 mm away from the upper side. On each horizontal measurement line, thickness measurement is performed at intervals of 1 mm in a horizontal direction with a starting point of less than 1 mm (however, not 0 mm) from the left side; and

An absolute value of a difference between a maximum value and a minimum value of the thickness is calculated for each of the four thickness measurement regions, and a value obtained by averaging the absolute values is set as the absolute value $D_1$ of the difference between the maximum value and the minimum value of the thickness, in addition, an average thickness of all the points in the four thickness measurement regions is calculated, and this average thickness is set as the average thickness $T_1$ of the metal clad laminate.

[2] The substrate according to [1], in which the metal clad laminate has the metal foil on both surfaces, and one or more cured products of the prepreg are provided between the metal foils on both surfaces.

[3] The substrate according to [1] or [2], in which the metal clad laminate has 2 to 20 cured products of the prepreg.

[4] The substrate according to any one of [1] to [3], in which the prepreg contains a fiber base material having a thickness of 40 $\mu$m or more and a thermosetting resin composition.

[5] The substrate according to any one of [1] to [4], in which the insulating layer is laminated on both surfaces of the metal clad laminate.

[6] The substrate according to any one of [1] to [5], in which the insulating layer is a cured product of a film-shaped thermosetting resin composition.

[7] The substrate according to any one of [1] to [6], in which an average thickness $T_2$ of the insulating layer is 5 to 100 $\mu$m.

[8] A printed wiring board including the substrate according to any one of [1] to [7].

[9] A semiconductor package including the printed wiring board according to [8], and a semiconductor element.

Advantageous Effects of Invention

According to the present embodiment, it is possible to provide a substrate having a small variation in characteristic impedance, a printed wiring board using the substrate, and a semiconductor package.

Brief Description of Drawings

Fig. 1 is a schematic view ((a) and (b)) illustrating a method for measuring a thickness of a metal clad laminate.
Fig. 2 is a perspective view of an example of a measurement site of a non-contact type and insertion type laser displacement gauge used in measurement of a thickness of a metal clad laminate.
Fig. 3 is a schematic view of an example of a sensor head of a laser displacement gauge used in measurement of a thickness of a metal clad laminate.
Fig. 4 is a schematic cross-sectional view showing one embodiment of a prepreg used for a metal clad laminate.
Fig. 5 is a surface observation image obtained by converting a surface observation image used in calculation of an abundance ratio of an impregnated region into a monochrome mode in a prepreg prepared in Example 1.
Fig. 6 is a schematic view illustrating a method of specifying a thickness measurement region (N1 to N4) from a predetermined portion of four corners of a metal clad laminate when a thickness of the metal clad laminate is measured in examples and comparative examples.

Description of Embodiments

In the present description, a numerical range indicated by using "to" indicates a range including numerical values described before and after "to" as a minimum value and a maximum value, respectively.

For example, the representation of a numerical range "X to Y" (X and Y are real numbers) means a numerical range that is X or more and Y or less. Further, the representation of "X or more" in the description herein means X and a numerical value exceeding X. Furthermore, the representation of "Y or less" in the description herein means Y and a numerical value less than Y.

The lower limit value and the upper limit value of a numerical range described in the description herein can be arbitrarily combined with the lower limit value or the upper limit value of another numerical range, respectively.

In a numerical range described in the present description, the lower limit value or the upper limit value of the numerical range may be replaced with a value shown in examples.

Each component and material exemplified in the present description may be used alone or may be used in combination of two or more types thereof, unless particularly otherwise specified.

In the present description, when a plurality of substances corresponding to each component are present in a resin composition, the content of each component in the resin composition means the total amount of the plurality of substances present in the resin composition, unless particularly otherwise specified.

In the present description, a "solid content" refers to components other than solvents, and components in a liquid form at 25°C are also considered as a solid content.

In the description herein, "(meth)acrylate" means "acrylate" and "methacrylate" corresponding thereto. Similarly, the term "(meth)acrylic" means "acrylic" and "methacrylic" corresponding thereto, and the term "(meth)acryloyl" means "acryloyl" and "methacryloyl" corresponding thereto.

The "semi-cured product" in the present description is synonymous with the resin composition in the B-stage state in JIS K6800 (2006), and the "cured product" is synonymous with the resin composition in the C-stage state in JIS K6800 (2006).

The action mechanism described in the present description is a conjecture, and does not limit the mechanism by which the effect of the present embodiment is produced.

The present embodiment also includes any combination of the present description.

[Substrate]

A substrate of the present embodiment is a substrate including:

a metal clad laminate including a metal foil and a cured product of a prepreg; and
an insulating layer laminated on at least one surface of the metal clad laminate,
in which the metal clad laminate has 400 $\mu$m or more of an average thickness $T_1$ measured by the following method using a laser displacement gauge, and 10 $\mu$m or less of an absolute value $D_1$ of a difference between a maximum value and a minimum value of a thickness.

(Method for measuring average thickness $T_1$ and absolute value $D_1$ of difference between maximum value and minimum value of thickness of metal clad laminate)

In a plan view of the metal clad laminate, four rectangular thickness measurement regions each having a vertical length of 60 mm and a horizontal length of 60 mm are set at any positions not overlapping each other.

In the rectangular thickness measurement region, a vertical measurement line is set to twelve lines every 5 mm from a position 2.5 mm away from a left side. On each vertical measurement line, thickness measurement is performed at intervals of 1 mm in a longitudinal direction with a starting point of less than 1 mm (however, not 0 mm) from an upper side.

In addition, in the rectangular thickness measurement region, a horizontal measurement line is set to twelve lines every 5 mm from a position 2.5 mm away from the upper side. On each horizontal measurement line, thickness measurement is performed at intervals of 1 mm in a horizontal direction with a starting point of less than 1 mm (however, not 0 mm) from the left side.

An absolute value of a difference between a maximum value and a minimum value of the thickness is calculated for each of the four thickness measurement regions, and a value obtained by averaging the absolute values is set as the absolute value $D_1$ of the difference between the maximum value and the minimum value of the thickness. In addition, an average thickness of all the points in the four thickness measurement regions is calculated, and this average thickness is set as the average thickness $T_1$ of the metal clad laminate.

The "average" in the present embodiment means an arithmetic average. In addition, the cured product of the prepreg indicates a cured prepreg.

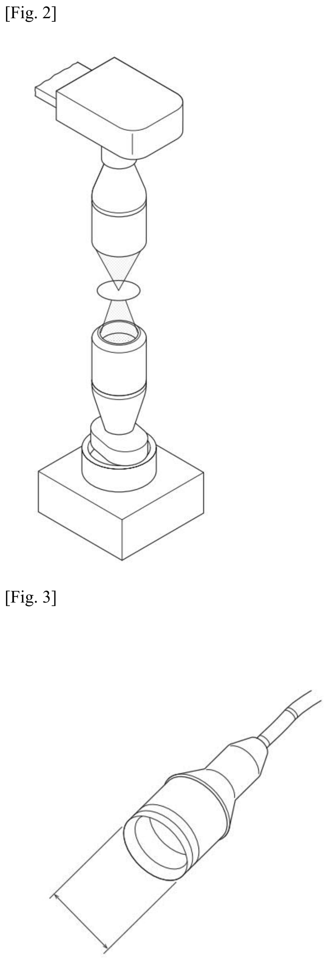

The thickness of the metal clad laminate can be measured using, for example, a non-contact type and insertion type laser displacement gauge shown in Fig. 2. These types of the laser displacement gauge measure a thickness by emitting a laser beam from both sides of a measurement target and detecting a distance to each surface of the measurement target through the reflected light.

More specifically, the thickness of the metal clad laminate can be measured by the laser displacement gauge and measurement conditions described in Examples.

As described above, in the method for measuring the average thickness $T_1$ and the absolute value $D_1$ of the difference between the maximum value and the minimum value of the thickness of the metal clad laminate of the present embodiment, four rectangular thickness measurement regions, each of which has a vertical length of 60 mm and a horizontal length of 60 mm, are set.

Meanwhile, when four rectangular thickness measurement regions having a vertical length of 60 mm and a horizontal length of 60 mm cannot be set due to the size of the metal clad laminate, the thickness measurement regions may be determined by the following method, and the average thickness and the absolute value of the difference between the maximum value and the minimum value of the thickness of the metal clad laminate may be calculated based on the method from the thickness measurement regions in accordance with the method described above. When the average thickness of the metal clad laminate calculated by this method is 400 $\mu$m or more and the absolute value of the difference between the maximum value and the minimum value of the thickness is 10 $\mu$m or less, the same effects as those of the substrate of the present embodiment can be produced. However, a lower limit of the thickness measurement region according to this method is a vertical length of 20 mm or more and a horizontal length of 20 mm or more.

For example, when only three or less rectangular thickness measurement regions having a vertical length of 60 mm and a horizontal length of 60 mm can be set, the maximum number of regions that can set a rectangular thickness measurement region having a vertical length of 60 mm and a horizontal length of 60 mm is set as a measurement target. In addition, when a size of the metal clad laminate in a surface direction is a square having a vertical length of less than 60 mm and a horizontal length of less than 60 mm, this is set as the thickness measurement region. When the size of the metal clad laminate in a surface direction is a rectangle having a vertical length of less than 60 mm or a horizontal length of less than 60 mm, the largest square that can be specified is set as the thickness measurement region. Even when the vertical length and the horizontal length of the thickness measurement region are less than 60 mm, a width of a measurement line is set to be the same as described above, and the total number of measurement lines may be smaller than twelve lines according to the vertical and horizontal lengths.

Preferable ranges of the average thickness and the absolute value of the difference between the maximum value and the minimum value of the thickness of the metal clad laminate calculated by the method are the same as preferable ranges of the average thickness $T_1$ and the absolute value $D_1$ of the difference between the maximum value and the minimum value of the thickness of the metal clad laminate of the substrate of the present embodiment.

<Metal clad laminate>

The metal clad laminate has a metal foil and a cured product of a prepreg.

The metal clad laminate includes a metal foil on at least one surface, and it is preferable that the metal clad laminate includes metal foils on both surfaces and includes one or more cured products of the prepreg between the metal foils on both surfaces. In addition, the metal clad laminate may or may not include a metal foil on any place other than both surfaces.

(Average thickness $T_1$ of metal clad laminate)

The average thickness $T_1$ of the metal clad laminate according to the measurement method described above is 400 $\mu$m or more.

In the substrate of the present embodiment, setting the average thickness $T_1$ of the metal clad laminate to be 400 $\mu$m or more makes the rigidity of the metal clad laminate sufficiently high when a semiconductor chip is laminated, thereby enabling to suppress the amount of warpage. Accordingly, it is particularly suitable as a substrate for a large semiconductor package.

From the above viewpoint, the average thickness $T_1$ of the metal clad laminate is preferably 500 $\mu$m or more, more preferably 700 $\mu$m or more, and further preferably 1,000 $\mu$m or more.

In addition, it is not desirable to make the average thickness $T_1$ of the metal clad laminate too much in view of size reduction and cost reduction, and it is preferably 2,500 $\mu$m or less, more preferably 2,000 $\mu$m or less, and further preferably 1,500 $\mu$m or less.

(Absolute value $D_1$ of difference between maximum value and minimum value of thickness of metal clad laminate)

The absolute value $D_1$ of the difference between the maximum value and the minimum value of the thickness of the metal clad laminate according to the measurement method described above is 10 $\mu$m or less.

When the absolute value $D_1$ of the difference between the maximum value and the minimum value of the thickness of the metal clad laminate is 10 $\mu$m or less, a variation in characteristic impedance of the substrate of the present embodiment becomes small.

From the above viewpoint, the absolute value $D_1$ of the difference between the maximum value and the minimum value of the thickness of the metal clad laminate is preferably 8 $\mu$m or less, more preferably 6 $\mu$m or less, and further preferably 5 $\mu$m or less.

The smaller the absolute value $D_1$ of the difference between the maximum value and the minimum value of the thickness of the metal clad laminate is, the more preferable it is, and may be 0 $\mu$m. However, in view of ease of production, it may be 0.1 $\mu$m or more, 0.5 $\mu$m or more, or 1 $\mu$m or more.

(Metal foil)

Examples of the metal foil of the metal clad laminate include a copper foil, an aluminum foil, a tin foil, a tin lead alloy foil, and a nickel foil. In addition, examples thereof include a three-layer structure composite foil in which nickel, nickel-phosphorus, a nickel-tin alloy, a nickel-iron alloy, lead, or a lead-tin alloy is set as an intermediate layer and a copper layer of 0.5 to 15 $\mu$m and a copper layer of 10 to 300 $\mu$m are provided on both surfaces thereof, and a two-layer structure composite foil in which aluminum and copper foils are combined. Among these, a copper foil is preferable.

A thickness of the metal foil is preferably 1 to 200 $\mu$m, more preferably 2 to 100 $\mu$m, further preferably 3 to 50 $\mu$m, and particularly preferably 3 to 20 $\mu$m.

(Prepreg)

The prepreg preferably contains a fiber base material and a thermosetting resin composition.

The number of cured products of the prepreg included in the metal clad laminate may be appropriately determined according to the use of the substrate, and may be 1 to 25, 2 to 20, 5 to 18, 8 to 16, or 10 to 14.

[Surface waviness (Wa) of Prepreg]

A surface waviness (Wa) of the prepreg is preferably 5.0 $\mu$m or less, more preferably 3.0 $\mu$m or less, and further preferably 2.0 $\mu$m or less, from the viewpoint of reducing the thickness variation of the metal clad laminate.

A lower limit value of the surface waviness (Wa) of the prepreg is not particularly limited, but may be 0.01 $\mu$m or more, 0.1 $\mu$m or more, or 0.2 $\mu$m or more.

The surface waviness (Wa) is an arithmetic average height (Wa), which can be obtained from a waviness curve in accordance with ISO 4287 (1997). Instead of ISO 4287 (1997), JIS B 0601 (2001) may be used. The surface waviness (Wa) can be measured as follows.

-Method for measuring surface waviness (Wa) of prepreg-

Using a shape analysis laser microscope "VK-X100" (manufactured by KEYENCE CORPORATION), shape measurement is automatically performed by an observation application, and a waviness curve in accordance with ISO 4287 (1997) or JIS B 0601 (2001) is obtained. The obtained waviness curve can be subjected to surface roughness analysis using an analysis application to calculate the surface waviness (Wa). Here, the waviness curve is a curve obtained by applying a phase compensation type high-pass filter $\lambda$c ($\lambda$c = 80 $\mu$m) to a cross-sectional curve and removing wavelengths less than 80 $\mu$m from the cross-sectional curve. In addition, an analysis range is set to 1,000 $\mu$m $\times$ 1,000 $\mu$m.

Unless otherwise specified, the surface waviness (Wa) of the prepreg is surface waviness of both surfaces of the prepreg.

[Unimpregnated region of prepreg]

The prepreg preferably has an impregnated region and an unimpregnated region of the thermosetting resin composition in the fiber base material, from the viewpoint of reducing the thickness variation of the metal clad laminate.

By forming the impregnated region and the unimpregnated region of the thermosetting resin composition in the fiber base material, the surface waviness (Wa) of the prepreg tends to be small even when the thickness of the fiber base material is large. Specifically, for example, even when a fiber base material having a thickness of 40 $\mu$m or more is used, the surface waviness (Wa) tends to be suppressed to 5.0 $\mu$m or less.

The mechanism of exhibiting the above effect is not clear, but is considered as follows.

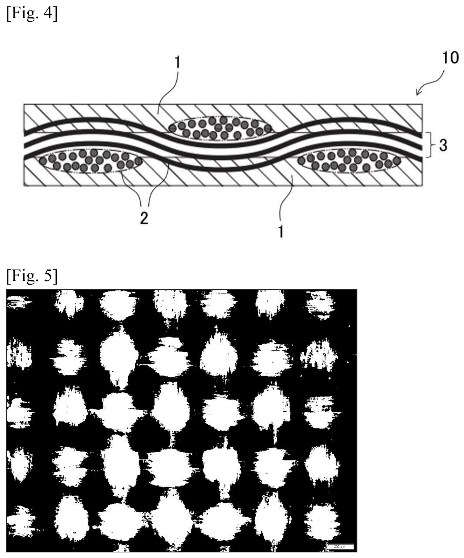

Fig. 4 shows a schematic cross-sectional view of one embodiment of a prepreg 10 used for a metal clad laminate. By intentionally providing a unimpregnated region 3 in which a thermosetting resin composition 1 is not impregnated in a fiber base material 2 as in the prepreg 10, a layer of the thermosetting resin composition 1 in the vicinity of the surface (hereinafter, also referred to as a "resin layer") is present without being aligned with the waviness of the fiber base material 2. As a result, it is considered that large waviness of the fiber base material 2 is less likely to be reflected on the surface of the prepreg 10, and the surface waviness (Wa) of the prepreg 10 becomes small.

Even in a case where the unimpregnated region is provided in the prepreg, the thermosetting resin composition flows in a thickness direction and flows into the unimpregnated region in press forming when producing the metal clad laminate. Accordingly, generation of voids in the metal clad laminate is sufficiently suppressed.

The presence of the unimpregnated region can be confirmed by obtaining an abundance ratio of the impregnated region of the thermosetting resin composition in the fiber base material. That is, when the abundance ratio of the impregnated region is not 100%, it means that there is the unimpregnated region.

The abundance ratio of the impregnated region can be measured by, for example, the following measurement method. From the viewpoint of reducing the thickness variation of the metal clad laminate, the abundance ratio of the impregnated region obtained based on the following method is preferably 20% to 99%, more preferably 30% to 98%, and further preferably 50% to 95%.

-Measurement method of impregnated region of prepreg-

A surface observation image is obtained by observing the surface of the prepreg at a magnification of 50 times using an optical microscope. As the observation conditions, the observation conditions described in Examples are used in detail from the viewpoint of imaging with appropriate brightness.

The obtained surface observation image is converted into a monochrome mode by image editing software, and stored in a Microsoft Windows Bitmap Image (BMP) format. Next, the surface observation image in the monochrome mode stored in the BMP format is converted into Red, Green, Blue (RGB) values for each pixel by image conversion software, and stored in a comma-separated values (CSV) format. The RGB data stored in CSV format is attached to Microsoft Excel (manufactured by Microsoft Corporation) to calculate an area of a black portion (RGB value = 255) and a white portion (RGB value = 0). From these values, an area ratio of the black portion to a total of the black portion and the white portion is obtained. The area ratio of the black portion thus obtained is defined as the abundance ratio of the impregnated region.

As the image editing software, for example, "Microsoft Paint" (manufactured by Microsoft Corporation) can be used. In addition, as the image conversion software, for example, "bmp2csv", which is a free software, can be used.

In the observation, when the surface observation image photographed with appropriate brightness is converted into the monochrome mode, a surface in which the unimpregnated region of the thermosetting resin composition is present in a lower portion of the observed surface is a void portion and is likely to reflect light, and thus is represented by "white", and the other surface is represented by "black". Here, when the surface observation image is imaged, it is preferable to adjust the exposure time at the time of imaging the surfaces in the range of 60 to 100 ms because imaging is performed with appropriate brightness so that the impregnated region and the unimpregnated region can be sufficiently reflected. In the surface observation image of the prepreg, a "region where glass cloth is not present in a resin layer", a "region where glass cloth is sufficiently impregnated with a thermosetting resin composition", and a "region where the glass cloth is not sufficiently impregnated with the thermosetting resin composition" are arranged in descending order of color intensity. In the present embodiment, the "region where the glass cloth is not present in the resin layer" is also included in the impregnated region. When the surface observation image is too bright, in the surface observation image in the monochrome mode, not only a portion where the impregnation of the glass cloth with the resin is insufficient, but a portion where the glass cloth is sufficiently impregnated with the resin is also likely to be represented as white. In addition, when the image is bright, the surface observation image in the monochrome mode tends to become white as a whole. On the other hand, when the surface observation image is too dark, the surface observation image in the monochrome mode becomes black as a whole, and the presence of the unimpregnated region tends to be less likely to be reflected. Therefore, it is preferable to perform imaging at an appropriate brightness. Fig. 5 shows a surface observation image converted into the monochrome mode obtained in Example 1 as an example in which the surface observation image photographed with appropriate brightness is converted into the monochrome mode.

In addition, the area ratio of the white portion to the total of the white portion and the black portion can be easily calculated by using a COUNTIF function of Microsoft Excel (manufactured by Microsoft Corporation).

[Thickness of prepreg]

A thickness of the prepreg may be appropriately determined depending on a thickness of the fiber base material, and is preferably 50 to 300 $\mu$m, more preferably 60 to 200 $\mu$m, and further preferably 70 to 150 $\mu$m.

The thickness of the prepreg refers to a thickness of one prepreg. In addition, the thickness of the prepreg is an average value obtained by measuring five arbitrary points with Digimatic Indicator.

[Thermosetting resin composition]

The thermosetting resin composition is not particularly limited as long as it contains a thermosetting resin.

-Thermosetting resin-

Examples of the thermosetting resin include an epoxy resin, a polyimide resin, a maleimide resin, a modified maleimide resin, a phenol resin, a polyphenylene ether resin, a bismaleimide-triazine resin, a cyanate resin, an isocyanate resin, a benzoxazine resin, an oxetane resin, an amino resin, an unsaturated polyester resin, an allyl resin, a dicyclopentadiene resin, a silicone resin, a triazine resin, and a melamine resin. Among these, from the viewpoint of formability and electrical insulation property, an epoxy resin, a polyimide resin, a maleimide resin, a modified maleimide resin, and a cyanate resin, are preferable, and an epoxy resin, a maleimide resin, and a modified maleimide resin are more preferable.

The thermosetting resin may be used alone or may be used in combination of two or more types.

Examples of the modified maleimide resin include a reaction product of a maleimide resin having two or more N-substituted maleimide groups and one or more types of compound selected from the group consisting of a monoamine compound and a diamine compound.

The maleimide resin having two or more N-substituted maleimide groups is preferably a bismaleimide resin having two N-substituted maleimide groups, and more preferably an aromatic bismaleimide resin having two N-substituted maleimide groups.

The monoamine compound is preferably a monoamine compound having an acidic substituent such as aminophenol and an aminobenzoic acid.

The diamine compound is preferably a diamine compound having two primary amino groups, and more preferably an aromatic diamine compound having two primary amino groups.

The epoxy resin is preferably an epoxy resin having two or more epoxy groups in one molecule. Here, the epoxy resin is classified into a glycidyl ether type epoxy resin, a glycidyl amine type epoxy resin, and a glycidyl ester type epoxy resin. Among them, a glycidyl ether type epoxy resin is preferable.

The epoxy resin is also classified into various epoxy resins depending on the difference in the main skeleton. For example, the above-mentioned respective types of epoxy resins are further classified into a bisphenol type epoxy resin; an alicyclic epoxy resin; an aliphatic chain epoxy resin; a novolac type epoxy resin; a stilbene type epoxy resin; a naphthalene skeleton-containing type epoxy resin; a biphenyl type epoxy resin; a xylylene type epoxy resin; and a dihydroanthracene type epoxy resin. Among these, a naphthalene skeleton-containing type epoxy resin is preferable from the viewpoint of insulation reliability and heat resistance.

The content of the thermosetting resin in the thermosetting resin composition is preferably 10 to 100 mass%, more preferably 20 to 80 mass%, and further preferably 30 to 70 mass% with respect to the total solid content (100 mass%) of the thermosetting resin composition from the viewpoint of heat resistance and formability.

-Curing accelerator-

It is preferable that the thermosetting resin composition further contains a curing accelerator.

As the curing accelerator, a general curing accelerator used for curing the thermosetting resin can be used. For example, when the thermosetting resin contains an epoxy resin, examples of the curing accelerator include an imidazole compound and a derivative thereof, a phosphorus compound, a tertiary amine compound, and a quaternary ammonium compound. Among these, an imidazole compound and a derivative thereof are preferable from the viewpoint of promoting the curing reaction.

Examples of the imidazole compound and the derivative thereof include an imidazole compound such as 2-methylimidazole, 2-ethylimidazole, 2-undecylimidazole, 2-phenylimidazole, 1,2-dimethylimidazole, and 2,4-diamino-6-[2'-undecylimidazolyl-(1)']-ethylS-triazine; a salt of the imidazole compound and trimellitic acid, such as 1-cyanoethyl-2-phenylimidazolium trimellitate; a salt of the imidazole compound and isocyanuric acid; and a salt of the imidazole compound and hydrogen bromide acid. Among these, an imidazole compound is preferable, and 2,4-diamino-6-[2'-undecylimidazolyl-(1)']-ethyl-S-triazine is more preferable.

When the thermosetting resin composition contains the curing accelerator, the content of the curing accelerator in the thermosetting resin composition is preferably 0.01 to 20 parts by mass, more preferably 0.1 to 10 parts by mass, and further preferably 0.5 to 3 parts by mass with respect to 100 parts by mass of the thermosetting resin from the viewpoint of the curing accelerating effect and the storage stability.

-Inorganic filler-

It is preferable that the thermosetting resin composition further contains an inorganic filler.

Examples of the inorganic filler include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, talc, aluminum borate, and silicon carbide. Among these, from the viewpoint of low thermal expansion property, heat resistance, and flame retardancy, silica, alumina, aluminum hydroxide, mica, and talc are preferable, and silica and aluminum hydroxide are more preferable.

The silica is preferably fused silica from the viewpoint of dispersibility and formability.

The inorganic filler may be surface-treated with a surface treatment agent such as a silane coupling agent in order to improve moisture resistance, or may be subjected to a hydrophobic treatment in order to improve dispersibility.

When the thermosetting resin composition contains the inorganic filler, the content of the inorganic filler in the thermosetting resin composition is preferably 10 to 90 mass%, more preferably 20 to 80 mass%, and further preferably 30 to 70 mass% with respect to the total solid content (100 mass%) from the viewpoint of low thermal expansion property and formability.

-Other components-

The thermosetting resin composition may further contain other components such as a resin material other than the components described above, a flame retardant, an antioxidant, a heat stabilizer, an antistatic agent, an ultraviolet absorbent, a pigment, a colorant, a lubricant, an organic solvent, and other additives, as necessary.

Each of these other components may be used alone, or in combination of two or more types.

The content of the other components in the thermosetting resin composition is not particularly limited, and may be used within a range of not impairing the effects of the present embodiment, as necessary.

In addition, the thermosetting resin composition may not contain the other components in accordance with desired performance.

The thermosetting resin composition can be produced by mixing the respective components. At this time, the respective components may be dissolved or dispersed while stirring using an organic solvent as necessary. Conditions such as a mixing order, a temperature, and a time are not particularly limited, and may be arbitrarily set according to the type of raw material or the like.

[Fiber base material]

As the fiber base material contained in the prepreg, known materials used in various laminates for electrical insulating materials can be used. Examples of the material of the fiber base material include natural fibers such as paper and cotton linter; inorganic fibers such as glass fiber and asbestos; organic fibers such as aramid, polyimide, polyvinyl alcohol, polyester, tetrafluoroethylene, and acryl; and mixtures thereof. Among these, from the viewpoint of flame retardancy, inorganic fibers are preferable, and glass fiber is more preferable. Examples of the glass fiber include glass fibers using E-glass, C-glass, D-glass, or S-glass.

The shape of the fiber base material is not particularly limited, and may be a woven fabric, a nonwoven fabric, a roving, a chopped strand mat, and a surfacing mat. Among these, a woven fabric is preferable. That is, the fiber base material is preferably a glass cloth.

A thickness of the fiber base material is preferably 40 $\mu$m or more from the viewpoint of handleability of the prepreg. That is, the prepreg is preferably a prepreg containing a fiber base material having a thickness of 40 $\mu$m or more and a thermosetting resin composition.

From the same viewpoint as described above, the thickness of the fiber base material is more preferably 60 $\mu$m or more, further preferably 70 $\mu$m or more, and particularly preferably 80 $\mu$m or more. In addition, from the viewpoint of thinning the substrate, the thickness of the fiber base material is preferably 120 $\mu$m or less, more preferably 110 $\mu$m or less, and further preferably 100 $\mu$m or less.

As the thickness of the fiber base material is large, the surface waviness of the fiber base material itself tends to increase. However, as described above, by providing the impregnated region and the unimpregnated region in the prepreg, even when the thickness of the fiber base material is 40 $\mu$m or more, the surface waviness (Wa) of the prepreg is suppressed to be small, and the thickness variation of the metal clad laminate can be reduced.

[Method for producing prepreg]

The method for producing the prepreg may be, for example, a method of laminating a film-shaped thermosetting resin composition (hereinafter, also referred to as a "resin film") on a fiber base material (hereinafter, also referred to as a "lamination method"), or a method of immersing a fiber base material in a thermosetting resin composition diluted with an organic solvent and then drying the thermosetting resin composition (hereinafter, also referred to as an "immersion method"). Among these, the lamination method is preferable from the viewpoint of easily reducing the thickness variation of the metal clad laminate.

Hereinafter, the lamination method will be described.

The resin film used in the lamination method is preferably a support-attached resin film having a support on one surface.

The support-attached resin film can be produced by, for example, a method of applying a varnish-like thermosetting resin composition (hereinafter, also referred to as a "resin varnish") to one surface of a support and drying the thermosetting resin composition.

The resin varnish can be applied, for example, using a known coating device such as a comma coater, a bar coater, a kiss coater, a roll coater, a gravure coater, or a die coater.

The drying temperature and the drying time after the application of the resin varnish may be appropriately determined depending on the type and the amount of the organic solvent used. For example, in the case of a resin varnish containing 30 to 70 mass% of an organic solvent, a resin film can be suitably formed by drying at 50 to 160°C for 1 to 8 minutes.

The thickness of the resin film may be appropriately determined according to the thickness of the prepreg or the like, and, when the thickness of the fiber base material is, for example, 40 to 120 $\mu$m, the thickness of the resin film is preferably 10 to 100 $\mu$m, more preferably 15 to 70 $\mu$m, and further preferably 20 to 50 $\mu$m.

Examples of the support include an organic film such as polyethylene terephthalate (PET), biaxially oriented polypropylene (OPP), polyethylene, polyvinyl fluoride, and polyimide; and a metal foil of a metal such as copper and aluminum or an alloy. The support thereof may be release-treated with a releasing agent.

The thickness of the support is, for example, 10 to 200 $\mu$m from the viewpoint of handleability and economy when the thermosetting resin composition is applied.

In the lamination of the resin film on the fiber base material, first, the support-attached resin film is arranged on at least one surface of the fiber base material in a direction that the resin film and the fiber base material are in contact with each other. Next, the fiber base material is impregnated with the resin film by heating and pressurizing the arranged support-attached resin film and the fiber base material. The support-attached resin film is preferably arranged and laminated on both surfaces of the fiber base material.

Examples of the lamination method include (a) roll lamination and (b) a method of laminating under reduced pressure.

(a) When the roll lamination is performed, a heating temperature may be 80 to 180°C, or may be 100 to 150°C. In addition, the applied pressure may be 0.05 to 1.0 MPa, or may be 0.2 to 0.6 MPa. In addition, a feed rate may be 0.5 to 7.0 m/min, or may be 1.0 to 4.0 m/min.

(b) When laminating is performed under reduced pressure, a heating temperature may be 80 to 180°C, or may be 100 to 150°C. In addition, a vacuum time may be 10 to 120 seconds, or may be 20 to 80 seconds. In addition, a pressurization time may be 10 to 120 seconds, or may be 20 to 80 seconds. In addition, a pressure bonding pressure may be 0.05 to 1.0 MPa, or may be 0.1 to 0.6 MPa. The method of laminating under reduced pressure can be performed using a vacuum laminating device.

Examples of the method of providing the unimpregnated region of the thermosetting resin composition in the fiber base material include a method of adjusting conditions for heating and pressurizing the support-attached resin film and the fiber base material.

Here, when the same lamination conditions are set for a case where the fiber base material is thin and a case where the fiber base material is thick, the resin film tends to be difficult to be impregnated into the fiber base material in the case where the fiber base material is thick. Therefore, even when the conventional conditions for laminating a resin film on a thin fiber base material are similar to the lamination conditions of the present embodiments, it is possible to provide the unimpregnated region of the thermosetting resin composition in the fiber base material in the present embodiments.

As a specific method for adjusting the heating and pressurizing conditions, for example, first, a prepreg is prepared under predetermined heating and pressurizing conditions, and then the abundance ratio of the impregnated region of the thermosetting resin composition in the fiber base material is obtained based on the above-described calculation method. As a result, in a case where the impregnated region is 100%, that is, in a case where there is no unimpregnated region, the heating temperature or the applied pressure is lowered, or both the heating temperature and the applied pressure are lowered, the prepreg is prepared again, and the abundance ratio of the impregnated region is obtained again. By further repeating this as necessary, it is possible to easily obtain the conditions for producing a prepreg having the unimpregnated region.

In addition, in a case where it is desired to adjust the abundance ratio of the unimpregnated region to be low, the prepreg may be produced again by increasing the heating temperature, or increasing the applied pressure, or increasing both the heating temperature and the applied pressure.

In the case of laminating under reduced pressure, it is also possible to adjust the abundance ratio of the unimpregnated region by adjusting a degree of vacuum.

(Method for producing metal clad laminate)

The metal clad laminate can be produced by a method for stacking a prepreg and a metal foil in the order for obtaining a desired configuration and then for performing press forming.

The heating temperature during press forming is preferably 130 to 350°C, more preferably 150 to 300°C, and further preferably 170 to 250°C.

The holding time at a maximum temperature during press forming is preferably 10 to 240 minutes, more preferably 30 to 180 minutes, and further preferably 60 to 120 minutes.

The pressure bonding pressure during the press forming is preferably 0.5 to 10 MPa, more preferably 1 to 7 MPa, and further preferably 2 to 5 MPa.

<Insulating layer>

The substrate of the present embodiment includes an insulating layer laminated on at least one surface of the metal clad laminate.

The insulating layer is laminated on at least one surface of the metal clad laminate, and is preferably laminated on both surfaces of the metal clad laminate.

The insulating layer may be a cured product of a prepreg or a cured product of a film-shaped thermosetting resin composition.

As the prepreg used for an insulating layer forming material, for example, the same prepreg as the prepreg used for producing the metal clad laminate can be used.

As the film-shaped thermosetting resin composition used for the insulating layer forming material, for example, the same resin film as the resin film used for producing the prepreg used for producing the metal clad laminate can be used.

(Average thickness $T_2$ of insulating layer)

The average thickness $T_2$ of the insulating layer is preferably 5 to 100 $\mu$m, more preferably 6 to 70 $\mu$m, and further preferably 8 to 50 $\mu$m.

When the average thickness $T_2$ of the insulating layer is the lower limit value described above or more, the insulating property tends to belikely to be better. When the average thickness $T_2$ of the insulating layer is the upper limit value described above or less, the substrate tends to be easily thinned.

The thickness of the insulating layer can be measured by the method described in Examples.

(Absolute value $D_2$ of difference between maximum value and minimum value of thickness of insulating layer)

The absolute value $D_2$ of the difference between the maximum value and the minimum value of the thickness of the insulating layer is preferably 10 $\mu$m or less, more preferably 8 $\mu$m or less, and further preferably 6 $\mu$m or less.

When the absolute value $D_2$ of the difference between the maximum value and the minimum value of the thickness of the insulating layer is the lower limit value described above or more, the variation in the characteristic impedance tends to be easily decreased.

The absolute value $D_2$ of the difference between the maximum value and the minimum value of the thickness of the insulating layer is preferably small, and may be 0 $\mu$m. However, from the viewpoint of ease of production, it may be 0.2 $\mu$m or more, 0.5 $\mu$m or more, or 1.0 $\mu$m or more.

The absolute value $D_2$ of the difference between the maximum value and the minimum value of the thickness of the insulating layer can be measured by the method described in Examples.

<Method for producing substrate>

The substrate of the present embodiment can be produced by laminating an insulating layer on at least one surface of a metal clad laminate.

Specifically, for example, press forming is performed after stacking an insulating layer forming material on one or both surfaces of the metal clad laminate, and then further stacking a metal foil on both outer sides thereof, as necessary, thereby allowing to laminate the insulating layer on at least one surface of the metal clad laminate.

As the metal foil, the same metal foil as the metal foil that can be included in the metal clad laminate can be used.

The heating temperature during press forming is preferably 130 to 350°C, more preferably 150 to 300°C, and further preferably 170 to 250°C.

The pressure bonding pressure during the press forming is preferably 0.5 to 10 MPa, more preferably 1 to 7 MPa, and further preferably 2 to 5 MPa.

In addition, the pressing time is preferably 10 to 240 minutes, more preferably 30 to 180 minutes, and further preferably 60 to 120 minutes.

[Printed wiring board]

The printed wiring board of the present embodiment is a printed wiring board including the substrate of the present embodiment.

The printed wiring board of the present embodiment can be produced by forming a conductor circuit on the substrate of the present embodiment. It is preferable that the conductor circuit is formed at least on the insulating layer of the substrate of the present embodiment.

The conductor circuit can be appropriately formed by a known method including performing a drilling process, a metal plating process, and etching of a metal foil.

A multilayer printed wiring board can also be produced by performing a multilayer adhesion process as necessary.

[Semiconductor package]

The semiconductor package of the present embodiment is a semiconductor package including the printed wiring board of the present embodiment and a semiconductor element.

The semiconductor package of the present embodiment can be produced, for example, by mounting a semiconductor chip, a memory, and the like on the printed wiring board of the present embodiment using a known method.

[Examples]

Hereinafter, the present embodiment will be specifically described with reference to Examples. However, the present embodiment is not limited to the following examples.

[Surface waviness (Wa)]

Using a shape analysis laser microscope "VK-X100" (manufactured by KEYENCE CORPORATION), shape measurement of the prepreg produced in each example was automatically performed by an observation application, and a waviness curve in accordance with ISO 4287 (1997) was obtained. The obtained waviness curve was subjected to surface roughness analysis using an analysis application to calculate the surface waviness (Wa) of the prepreg. Here, the waviness curve is a curve obtained by applying a phase compensation type high-pass filter $\lambda c$ ($\lambda c = 80\ \mu m$) to a cross-sectional curve and removing wavelengths less than 80 $\mu m$ from the cross-sectional curve. The analysis range was set to 1,000 $\mu m \times$ 1,000 $\mu m$.

The surface waviness (Wa) was measured on both surfaces of the prepreg, and the larger value was adopted.

[Abundance ratio of impregnated region]

The abundance ratio (%) of the impregnated region of the thermosetting resin composition in the fiber base material of the prepreg produced in each example was obtained based on the following calculation method.

-Calculation method-

Surface observation images were obtained by observing the surfaces of the prepregs under the following conditions using an optical microscope (manufactured by Olympus Corporation, trade name "MX61L-F").

<Observation conditions>

· Magnification: 50 times
· Observation mode: dark field
· Sensibility: ISO400
· Exposure time at the time of imaging surface: 60 to 100 ms
· Brightness of observation environment: Two of 35 W fluorescent lamps are installed 2 m above the observation stage.

The obtained surface observation image was converted into a monochrome mode by image editing software, and stored in a Microsoft Windows Bitmap Image (BMP) format. Next, the surface observation image in the monochrome mode stored in the BMP format was converted into Red, Green, Blue (RGB) values for each pixel by image conversion software, and stored in a comma-separated values (CSV) format. The RGB data stored in CSV format was attached to Microsoft Excel (manufactured by Microsoft Corporation) to calculate an area of a black portion (RGB value = 255) and a white portion (RGB value = 0). From these values, an area ratio of the black portion to a total of the black portion and the white portion was obtained. The area ratio of the black portion thus obtained was defined as the abundance ratio (%) of the impregnated region.

Here, when the surface observation image was photographed, as described above, the exposure time at the time of imaging the surface was adjusted within 60 to 100 ms so that the impregnated region and the unimpregnated region are sufficiently reflected, thereby imaging with an appropriate brightness.

As the image editing software, "Microsoft Paint" (manufactured by Microsoft Corporation) was used. As the image conversion software, "bmp2csv", which is free software, was used.

[Method for measuring average thickness $T_1$ of metal clad laminate and absolute value $D_1$ of difference between maximum value and minimum value of thickness of metal clad laminate]

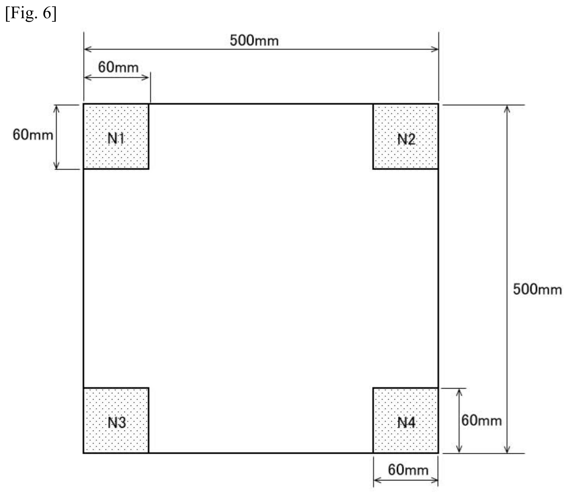

From four corners (see Fig. 6) of the metal clad laminate produced in each example, rectangular thickness measurement regions (N1 to N4) having a vertical length of 60 mm and a horizontal length of 60 mm were set in a plan view of the metal clad laminate.

Next, the thicknesses of the thickness measurement regions (N1 to N4) were measured by the following procedure using a non-contact type and insertion type laser displacement gauge "CL-3000 series (sensor head: CL-L015)" (a multi-color laser coaxial displacement gauge, manufactured by KEYENCE CORPORATION). The measurement conditions were set to have a measurement rate of 10 mm/sec, 1 measurement range of 300 $\mu$m in diameter, a resolution of 0.003 $\mu$m, a repeat accuracy of 0.3 $\mu$m or less, and a sensor head size (an arrow part of Fig. 3) of 26 mm in diameter. The repeat accuracy means a degree of variation when repeatedly measured at a fixed point of an object to be measured, and as the repeat accuracy is small, the degree of variation of values obtained by the repeated measurement is small.

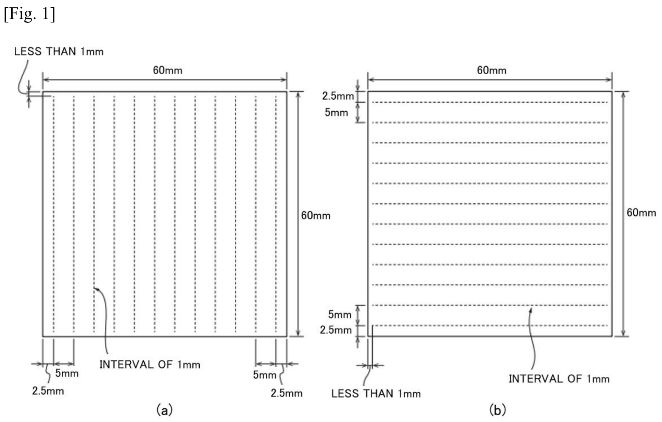

First, as shown in Fig. 1(a), in the rectangular thickness measurement region, a vertical measurement line is set to twelve lines every 5 mm from a position 2.5 mm away from a left side. On each vertical measurement line, thickness measurement was performed at intervals of 1 mm in a longitudinal direction with a starting point of less than 1 mm (however, not 0 mm) from an upper side.

Next, as shown in Fig. 1(b), in the rectangular thickness measurement region, a horizontal measurement line is set to twelve lines every 5 mm from a position 2.5 mm away from the upper side. On each horizontal measurement line, thickness measurement was performed at intervals of 1 mm in a horizontal direction with a starting point of less than 1 mm (however, not 0 mm) from the left side.

Accordingly, the thicknesses of 1440 points (here, even when there was a point where measurement points overlap in the vertical and horizontal measurement lines, each one was counted as one point) were measured per one thickness measurement region.

From the thicknesses obtained by the above method, an absolute value of a difference between a maximum value and a minimum value of the thickness was calculated for each of the four thickness measurement regions (N1 to N4), and a value obtained by averaging these was set as the absolute value $D_1$ of the difference between the maximum value and the minimum value of the thickness of the metal clad laminate. In addition, a value obtained by averaging all the thicknesses obtained in the four thickness measurement regions (N1 to N4) was defined as the average thickness $T_1$ of the metal clad laminate.

[Method for measuring average thickness $T_2$ of insulating layer and absolute value $D_2$ of difference between maximum value and minimum value of thickness of insulating layer]

An average thickness of the substrate and an absolute value of a difference between a maximum value and a minimum value of the thickness of the substrate were obtained in the same manner as described above, except that a measurement target was changed to the substrate obtained in each example in the [Method for measuring average thickness $T_1$ of metal clad laminate and absolute value $D_1$ of difference between maximum value and minimum value of thickness of metal clad laminate] described above.

Next, the thickness of the insulating layer was obtained based on the following equation from the thickness of the substrate and the thickness of the metal clad laminate at the same point.

Thickness of insulating layer = [Thickness of substrate - thickness of metal clad laminate - thickness of copper foil]/2

The "thickness of copper foil" in the above equation means a thickness of a copper foil of the insulating layer laminated on a side opposite to the metal clad laminate.

From the thickness obtained by the above method, the average thickness $T_2$ of the insulating layer and the

absolute value $D_2$ of the difference between the maximum value and the minimum value of the thickness of the insulating layer were calculated by the same procedure as in the case of the metal clad laminate.

[Production of metal clad laminate]

Production Example 1

<Production of metal clad laminate 1>

(Preparation of modified maleimide resin)

Into a reaction vessel having a volume of 2 L which is capable of heating and cooling and is equipped with a thermometer, a stirring device, and a moisture quantitative determination instrument equipped with a reflux cooling pipe, 595.8 g of bis(4-maleimidophenyl)methane, 54.2 g of 4,4'-diaminodiphenylmethane, and 350.0 g of propylene glycol monomethyl ether were charged, and then reacted for 5 hours under reflux, thereby obtaining a solution of a modified maleimide resin (solid content concentration: 65 mass%).

(Production of resin varnish)

To 107 parts by mass of the solution of the modified maleimide resin obtained above, 30 parts by mass of a tetrafunctional naphthalene type epoxy resin "EXA-4710" (manufactured by DIC Corporation), 17.5 parts by mass of aluminum hydroxide, 130 parts by mass of fused silica, 0.5 parts by mass of 2,4-diamino-6-[2'-undecylimidazolyl-(1)']-ethyl-S-triazine, and methyl isobutyl ketone and cyclohexanone as diluting solvents were added and mixed to produce a resin varnish A having a solid content concentration of 65 mass% (content of aluminum hydroxide: 8 volume%, content of fused silica: 41.5 volume%).

(Production of resin film)

The resin varnish A obtained above was applied onto a PET film (manufactured by Toray Industries, Inc., thickness: 50 $\mu$m, trade name: S10) using a comma coater. At this time, the applied amount was adjusted so that a coating width was 530 mm and a thickness after drying was 30 $\mu$m. Thereafter, the film was heated and dried at 130°C for 2 minutes to produce a resin film with a PET film.

(Production of prepreg)

On both surfaces of a glass cloth "IPC # 2116" (manufactured by Nitto Boseki Co., Ltd., basis weight: 104 g/m$^2$, base material width: 530 mm, thickness: 91 $\mu$m) having a vertical length of 530 mm and a horizontal length of 530 mm, the resin film of the resin film with a PET film was disposed so as to be in contact with the glass cloth. A laminated body of the "PET film/resin film/glass cloth/resin film/PET film" was heated and pressurized under vacuum using a vacuum laminating device to obtain a prepreg with a PET film in which the glass cloth was impregnated with a thermosetting resin composition of the resin film. The conditions of the vacuum lamination were a hot plate temperature of 130°C, a pressure bonding pressure of 0.5 MPa, a vacuum degree of 100 kPa or less, a vacuum time of 30 seconds, and a heating time of 30 seconds. The PET film was peeled from the obtained prepreg with a PET film to obtain a prepreg 1 (thickness: 125 $\mu$m, surface waviness (Wa): 0.5 $\mu$m, abundance ratio of impregnated region: 62%).

A thickness of the prepreg was an average value of values obtained by measuring five arbitrary positions using a pedestal adjusted horizontally and a Digimatic Indicator (manufactured by Mitutoyo Corporation).

In addition, a content ratio of the thermosetting resin composition in the prepreg 1 was calculated as follows. A mass ($w_r$) of the resin film was calculated by subtracting a total mass of two PET films from a total mass of two resin films with a PET film used for producing the prepreg 1. Using the mass ($w_r$) of the resin film and the mass ($w_p$) of the prepreg 1, the content ratio of the thermosetting resin composition was obtained from the following equation.

$$\text{Content ratio (mass\%) of thermosetting resin composition} = (w_r/w_p) \times 100$$

(Production of metal clad laminate)

12 pieces of the prepreg 1 obtained above were stacked, and a copper foil "GTHMP-12" (manufactured by Furukawa Circuit Foil Taiwan Corporation) having a thickness of 12 $\mu$m was arranged above and below the laminate. Next, pressing was performed under the following conditions, and an end portion of the obtained metal clad laminate was cut to produce a rectangular metal clad laminate 1 having a size of 500 mm × 500 mm in a plan view.

-Pressing conditions-

Heating conditions: the temperature was raised from 25°C to 230°C at a temperature raising rate of 3°C/min, held at 230°C for 90 minutes, and then cooled for 30 minutes.
Pressure conditions (pressure applied to 12 pieces of the prepreg interposed between copper foils): 4 MPa (from the start of temperature rising to the end of cooling)

Production Example 2

<Production of metal clad laminate 2>

A laminated body of "PET film/resin film/glass cloth/resin film/PET film" was produced in the same procedure as in Production Example 1. Next, the laminated body was heated and pressurized using a pressure roll to obtain a prepreg with a PET film in which the glass cloth was impregnated with a thermosetting resin composition of the resin film. The conditions for the pressure roll were a roll temperature of 130°C, an applied pressure of 0.40 MPa, and a speed of 2.0 m/min. The PET film was peeled from the obtained prepreg with a PET film to obtain a prepreg 2 (thickness: 125 $\mu$m, surface waviness (Wa): 0.5 $\mu$m, abundance ratio of impregnated region: 68%). A thickness of the prepreg 2 and a content ratio of the thermosetting resin composition were obtained in the same manner as in Production Example 1.
A metal clad laminate 2 was produced in the same procedure as in Production Example 1 using the prepreg 2 obtained above.

Production Example 3

<Production of metal clad laminate 3>

After the same glass cloth as that used in Production Example 1 was immersed into the resin varnish A produced in Production Example 1, it is taken out, and then dried by heating at 140°C for 3.5 minutes to obtain a prepreg 3 (thickness: 125 $\mu$m, surface waviness (Wa): 5.7 $\mu$m). A metal clad laminate 3 was produced in the same procedure as in Production Example 1 using the prepreg 3.

[Production of substrate]

Examples 1 to 8 and Comparative Examples 1 to 5

Each one of a resin film (manufactured by Resonac Corporation, trade name "AS-400HS", resin film having the average thickness $T_2$ of the insulating layer shown in Table 1) was stacked above and below the type of the metal clad laminate shown in Table 1, further a copper foil (manufactured by Mitsui Mining & Smelting Co., Ltd., trade name: MT18FL, roughening treatment surface roughness Rz: 1.3 $\mu$m) having a thickness of 3 $\mu$m was stacked on both outer sides thereof, and press forming was performed under conditions of a temperature of 230°C, a pressure bonding pressure of 3.0 MPa, and a time of 80 minutes, thereby obtaining a metal clad laminate in which the insulating layer is laminated on both surfaces.

[Measurement of characteristic impedance]

A hole was formed at a desired position of a substrate obtained in each example, and a through hole was formed by electroless copper plating. In addition, one surface of the substrate was patterned by etching to form five microstrip lines with a line length of 50 mm, and the substrate formed with a pattern for contacting a high-frequency probe with one of the signal lines was set as a substrate for measuring characteristic impedance. The line width was designed so that the characteristic impedance was 50 $\Omega$ in consideration of the thickness of the insulating layer of each substrate.
In the measurement of the characteristic impedance, a product in which a high-frequency probe (manufactured by Form Factor, trade name: "ACP -65 GSG-250") and an oscilloscope attached with a TDR module (manufactured by Keysite Technology, trade name: "54750A", "54754A") were connected to each other via a coaxial cable (manufactured by HUBER-SUHNER, trade name: "SUCOFLEX 104") was used.
A high-frequency signal having a pulse rise time of 30 ps was incident from the oscilloscope, and the high-frequency probe was pressed against the pattern of the substrate for measuring the characteristic impedance produced as described above, and the characteristic impedance was calculated from a measured voltage. A difference between a maximum value and a minimum value of the characteristic impedance of 20 lines was defined as a variation of characteristic impedance (maximum value - minimum value). The results are shown in Table 1.

Table 1

| | | | Example | | | |
|---|---|---|---|---|---|---|
| | | | 1 | 2 | 3 | 4 |
| Substrate | Metal clad laminate | Type of metal clad laminate | Metal clad laminate 1 | Metal clad laminate 1 | Metal clad laminate 1 | Metal clad laminate 1 |
| | | Average Thickness $T_1$ (μm) | 1242 | 1242 | 1242 | 1242 |
| | | Absolute value $D_1$ of difference between maximum value and minimum value of thickness (μm) | 4 | 4 | 4 | 4 |
| | Insulating layer | Average Thickness $T_2$ (μm) | 10 | 20 | 25 | 30 |
| | | Absolute value $D_2$ of difference between maximum value and minimum value of thickness (μm) | 2 | 2 | 4 | 4 |
| Evaluation results | Characteristic impedance | Minimum Value (Ω) | 47.5 | 49.2 | 49.3 | 49.3 |
| | | Maximum value (Ω) | 52.7 | 51.2 | 50.7 | 50.3 |
| | | Variation in characteristic impedance (maximum value − minimum value) (Ω) | 5.2 | 2.0 | 1.4 | 1.0 |

Table 1 (continued)

| | | | Example | | | |
|---|---|---|---|---|---|---|
| | | | 5 | 6 | 7 | 8 |
| Substrate | Metal clad laminate | Type of metal clad laminate | Metal clad laminate 1 | Metal clad laminate 2 | Metal clad laminate 2 | Metal clad laminate 2 |
| | | Average Thickness $T_1$ (μm) | 1242 | 1243 | 1243 | 1243 |
| | | Absolute value $D_1$ of difference between maximum value and minimum value of thickness (μm) | 4 | 4 | 4 | 4 |
| | Insulating layer | Average Thickness $T_2$ (μm) | 40 | 10 | 25 | 40 |
| | | Absolute value $D_2$ of difference between maximum value and minimum value of thickness (μm) | 4 | 2 | 4 | 4 |
| Evaluation results | Characteristic impedance | Minimum Value (Ω) | 49.7 | 47.4 | 49.3 | 49.8 |
| | | Maximum value (Ω) | 50.2 | 52.7 | 50.7 | 50.2 |
| | | Variation in characteristic impedance (maximum value − minimum value) (Ω) | 0.5 | 5.3 | 1.4 | 0.4 |

Table 1 (continued)

| | | | Comparative Example | | | | |
| --- | --- | --- | --- | --- | --- | --- | --- |
| | | | 1 | 2 | 3 | 4 | 5 |
| Substrate | Metal clad laminate | Type of metal clad laminate | Metal clad laminate 3 | Metal clad laminate 3 | Metal clad laminate 3 | Metal clad laminate 3 | Metal clad laminate 3 |
| | | Average Thickness $T_1$ (μm) | 1231 | 1231 | 1231 | 1231 | 1231 |
| | | Absolute value $D_1$ of difference between maximum value and minimum value of thickness (μm) | 15 | 15 | 15 | 15 | 15 |
| | Insulating layer | Average Thickness $T_2$ (μm) | 10 | 20 | 25 | 30 | 40 |
| | | Absolute value $D_2$ of difference between maximum value and minimum value of thickness (μm) | 6 | 8 | 10 | 10 | 12 |
| Evaluation results | Characteristic impedance | Minimum Value (Ω) | 40.7 | 43.6 | 44.0 | 44.6 | 45.4 |
| | | Maximum value (Ω) | 57.5 | 56.3 | 55.0 | 55.0 | 53.2 |
| | | Variation in characteristic impedance (maximum value − minimum value) (Ω) | 16.8 | 12.7 | 11.0 | 10.4 | 7.8 |

Table 1 shows that the substrates of Examples 1 to 8 of the present embodiment have small variations in characteristic impedance. On the other hand, in the substrates of Comparative Examples 1 to 5 in which the absolute value $D_1$ of the difference between the maximum value and the minimum value of the thickness of the metal clad laminate exceeds 10 μm, the variation in the characteristic impedance was large.

Reference Signs List

1 Thermosetting resin composition
2 Fiber base material
3 Unimpregnated region
10 Prepreg

**Claims**

**1.** A substrate comprising:

a metal clad laminate including a metal foil and a cured product of a prepreg; and
an insulating layer laminated on at least one surface of the metal clad laminate,
wherein the metal clad laminate has 400 μm or more of an average thickness $T_1$ measured by the following method using a laser displacement gauge and 10 μm or less of an absolute value $D_1$ of a difference between a maximum value and a minimum value of a thickness,
(Method for measuring the average thickness $T_1$ and the absolute value $D_1$ of the difference between maximum value and minimum value of the thickness of the metal clad laminate):

In a plan view of the metal clad laminate, four rectangular thickness measurement regions each having a vertical length of 60 mm and a horizontal length of 60 mm are set at any positions not overlapping each other;
In the rectangular thickness measurement region, a vertical measurement line is set to twelve lines every 5 mm from a position 2.5 mm away from a left side, and on each vertical measurement line, thickness measurement is performed at intervals of 1 mm in a longitudinal direction with a starting point of less than 1 mm (however, not 0 mm) from an upper side;
In addition, in the rectangular thickness measurement region, a horizontal measurement line is set to twelve lines every 5 mm from a position 2.5 mm away from the upper side, and on each horizontal measurement line, thickness measurement is performed at intervals of 1 mm in a horizontal direction with a starting point of less than 1 mm (however, not 0 mm) from the left side; and

An absolute value of a difference between a maximum value and a minimum value of the thickness is calculated for each of the four thickness measurement regions, and a value obtained by averaging the absolute values is set as the absolute value $D_1$ of the difference between the maximum value and the minimum value of the thickness, in addition, an average thickness of all the points in the four thickness measurement regions is calculated, and this average thickness is set as the average thickness $T_1$ of the metal clad laminate.

2. The substrate according to claim 1,
   wherein the metal clad laminate has the metal foil on both surfaces, and one or more cured products of the prepreg are provided between the metal foils on both surfaces.

3. The substrate according to claim 1 or 2,
   wherein the metal clad laminate has 2 to 20 cured products of the prepreg.

4. The substrate according to claim 1 or 2,
   wherein the prepreg contains a fiber base material having a thickness of 40 $\mu$m or more and a thermosetting resin composition.

5. The substrate according to claim 1 or 2,
   wherein the insulating layer is laminated on both surfaces of the metal clad laminate.

6. The substrate according to claim 1 or 2,
   wherein the insulating layer is a cured product of a film-shaped thermosetting resin composition.

7. The substrate according to claim 1 or 2,
   wherein an average thickness $T_2$ of the insulating layer is 5 to 100 $\mu$m.

8. A printed wiring board comprising the substrate according to claim 1 or 2.

9. A semiconductor package comprising:

   the printed wiring board according to claim 8; and
   a semiconductor element.

[Fig. 1]

LESS THAN 1mm
60mm
60mm
5mm
2.5mm
INTERVAL OF 1mm
5mm
2.5mm
(a)

60mm
2.5mm
5mm
60mm
5mm
2.5mm
LESS THAN 1mm
INTERVAL OF 1mm
(b)

[Fig. 2]

[Fig. 3]

[Fig. 4]

[Fig. 5]

[Fig. 6]

## INTERNATIONAL SEARCH REPORT

International application No.

**PCT/JP2024/020031**

### A. CLASSIFICATION OF SUBJECT MATTER

*H05K 1/03*(2006.01)i; *B32B 15/08*(2006.01)i
FI:   H05K1/03 630H; H05K1/03 610T; B32B15/08 J

According to International Patent Classification (IPC) or to both national classification and IPC

### B. FIELDS SEARCHED

Minimum documentation searched (classification system followed by classification symbols)

H05K1/03; B32B15/08

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2022/254587 A1 (SHOWA DENKO MATERIALS CO., LTD.) 08 December 2022 (2022-12-08)<br>paragraphs [0011], [0046], [0048]-[0049], [0060] | 1-9 |
| Y | WO 2020/045112 A1 (MITSUBISHI GAS CHEMICAL COMPANY, INC.) 05 March 2020 (2020-03-05)<br>paragraphs [0034]-[0035], [0141]-[0143], fig. 1 | 1-9 |
| A | JP 2010-111115 A (HITACHI CHEM CO., LTD.) 20 May 2010 (2010-05-20) | 1-9 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **08 July 2024** | **16 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/020031**

| Patent document cited in search report | | | Publication date (day/month/year) | Patent family member(s) | | | Publication date (day/month/year) |
|---|---|---|---|---|---|---|---|
| WO | 2022/254587 | A1 | 08 December 2022 | EP | 4349558 | A1 | |
| | | | | paragraphs [0019], [0114], [0120]-[0122], [0156] | | | |
| | | | | WO | 2022/255278 | A1 | |
| | | | | CN | 117396318 | A | |
| | | | | KR | 10-2024-0015640 | A | |
| WO | 2020/045112 | A1 | 05 March 2020 | US | 2021/0204404 | A1 | |
| | | | | paragraphs [0056]-[0057], [0182]-[0187], fig. 1 | | | |
| | | | | EP | 3845379 | A1 | |
| | | | | CN | 112601662 | A | |
| | | | | KR | 10-2021-0052390 | A | |
| | | | | TW | 202019705 | A | |
| JP | 2010-111115 | A | 20 May 2010 | (Family: none) | | | |

Form PCT/ISA/210 (patent family annex) (July 2022)

**EP 4 730 922 A1**

**Patent documents cited in the description**

- JP 2002141670 A